# EUROPEAN PATENT APPLICATION

(11) **EP 4 723 836 A1**
(43) Date of publication of application: **08.04.2026**
(21) Application number: 25168193.8
(22) Date of filing: 03.04.2025
(51) Int. Cl.: H10D 89/60, H03K 17/0812

(54) **CIRCUIT INCLUDING SELF-PROTECTED TRANSISTOR**

(30) Priority: 01.10.2024 US 202418903064
(71) Applicant: GLOBALFOUNDRIES Singapore Pte. Ltd., Singapore 738406 (SG)
(72) Inventor: Hwang, Kyong Jin, 738406 Singapore (SG); Dobrichkov, Boris Danailov, 1700 Sofia (BG)
(74) Representative: Grünecker Patent- und Rechtsanwälte PartG mbB

(57) **Abstract**

Disclosed is a circuit including a transistor with integrated circuitry for protection against damage due to an electrostatic discharge (ESD) event or other drain voltage (Vd) overstress condition. The transistor is an N-type field effect transistor (NFET) and includes a drain region, a source region connected to ground, and a gate connected to a first node. The first node is connected to receive an externally-generated gate bias voltage. A resistor-capacitor (RC)-triggered voltage clamp is connected in parallel with the transistor. Specifically, a resistor is connected between the source region and a second node and a capacitor is connected between the second node and the drain region. A first diode or series-connected first diodes is/are connected between the second node and the first node. Optionally, a resistor-diode (RD)-triggered voltage clamp is also connected in parallel with the transistor and shares the resistor and second node with the RC-triggered voltage clamp.

## Description

### BACKGROUND

The present disclosure relates to integrated circuits (ICs) and, more particularly, to embodiments of a circuit including a self-protected transistor (e.g., an output driver transistor) with integrated circuitry for self-protection against damage due to an electrostatic discharge (ESD) event or some other drain voltage (Vd) overstress conditions.

N-type field effect transistors (NFETs) and particularly high voltage (HV) NFETs are often used in integrated circuits (ICs) as output drivers. Typically, when employed as an output driver, an NFET will have a source region connected to ground, a drain region connected to an output pad (and thereby to an external pin that can be contacted by humans or machines), and a gate connected to receive a gate bias voltage (Vgb) (also referred to herein as a drive voltage) (e.g., from a logic-controlled driver circuit). Such an NFET may, however, be at risk of damage due to an ESD event or some other Vd overstress condition, particularly when Vgb is at a level below the threshold voltage (Vt) of the NFET. Specifically, if Vgb is below Vt when an ESD event or some other Vd overstress condition occurs, the NFET will be non-conductive and unable to discharge the surging Vd to ground. If, as a result, any maximum voltage rating (e.g., a maximum drain-source voltage rating (maxVDS) and/or a maximum drain-gate voltage rating (maxVDG)) for the NFET is violated, then damage can occur. Protecting the NFET from such damage can be difficult (e.g., due to strong snapback, a narrow ESD window, etc.). Currently, available solutions for avoiding this type of damage include employing an NFET with a large channel width and/or connecting a resistance-capacitance (RC) circuit in parallel with the NFET. However, such solutions can increase chip area and can also cause switching delay during normal NFET operation.

### SUMMARY

Disclosed herein are embodiments of a circuit including a self-protected transistor. More specifically, in some embodiments disclosed herein a circuit can include a transistor. The transistor can include a source region, a drain region and a gate. The gate can be connected to a first node. The circuit can further include a resistor, which is connected between the source region and a second node, and a capacitor, which is connected between the second node and the drain region. The circuit can further include a first diode, which is connected between the second node and the first node. Optionally, the circuit can include a second diode, which is connected in parallel with the capacitor (i.e., between the second node and the drain region).

In other embodiments disclosed herein, the circuit can include a transistor. The transistor can include a source region, a drain region and a gate. The gate can be connected to a first node. The circuit can further include a resistor, which is connected between the source region and a second node, and a capacitor, which is connected between the second node and the drain region. The circuit can further include series-connected first diodes between the second node and the first node and either a second diode or a chain of series-connected second diodes connected in parallel with the capacitor between the second node and the drain region.

In still other embodiments disclosed herein, the circuit can include a transistor. The transistor can include a source region, a drain region and a gate. The gate can be connected to a first node. The circuit can further include a resistor, which is connected between the source region and a second node, and a capacitor, which is connected between the second node and the drain region. The circuit can further include either a first diode or a chain of series-connected first diodes connected between the second node and the first node. The circuit can further include a chain of series-connected second diodes connected in parallel with the capacitor between the second node and the drain region.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:

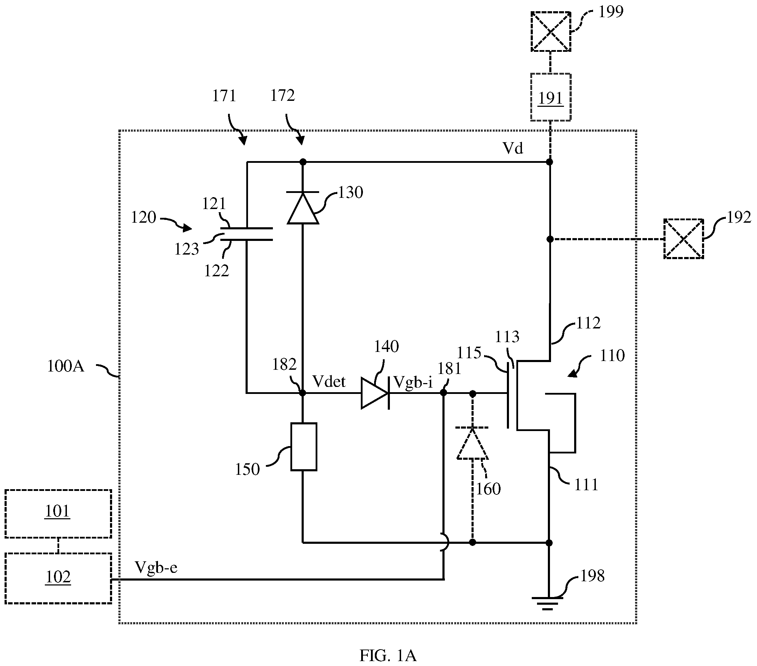

FIG. 1A is a schematic diagram illustrating an embodiment of a circuit with a self-protected transistor;

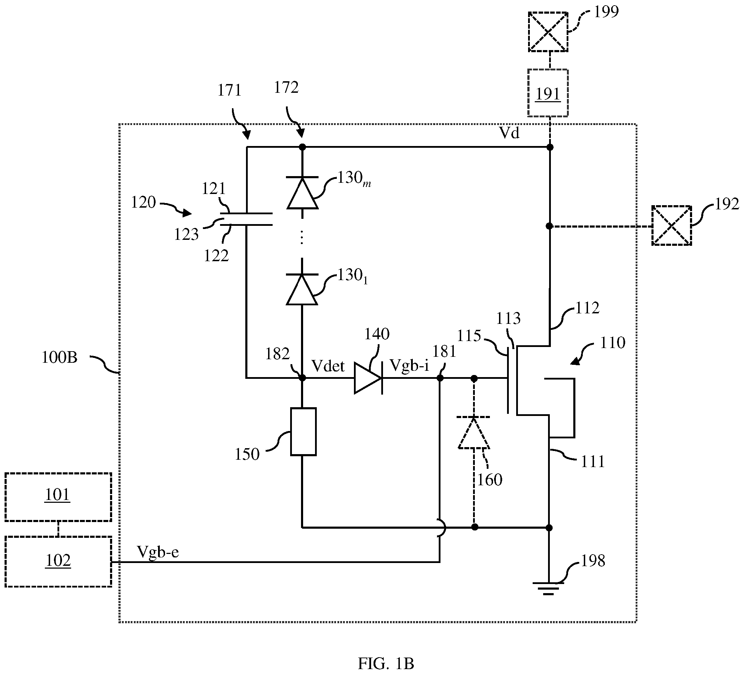

FIG. 1B is a schematic diagram illustrating another embodiment of a circuit with a self-protected transistor;

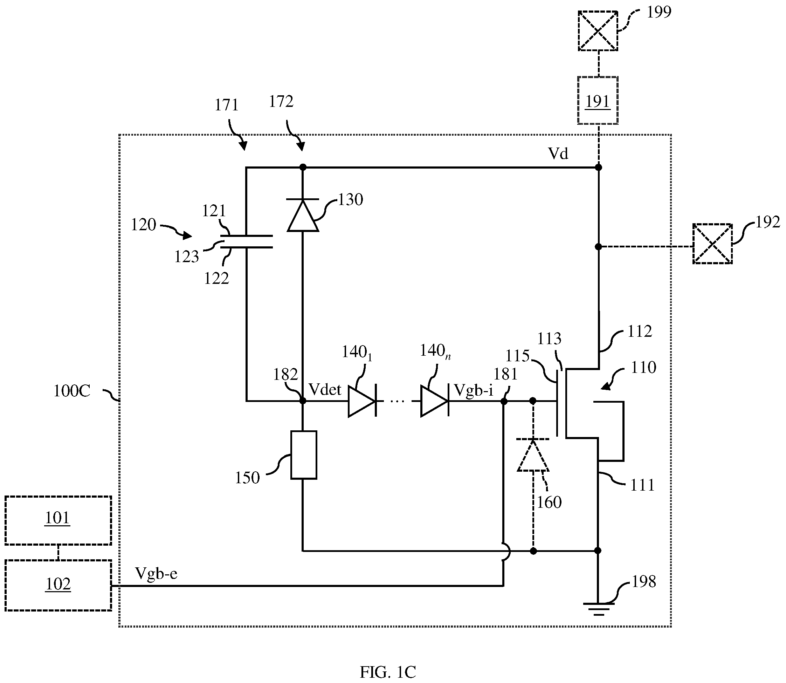

FIG. 1C is a schematic diagram illustrating yet another embodiment of a circuit with a self-protected transistor; and

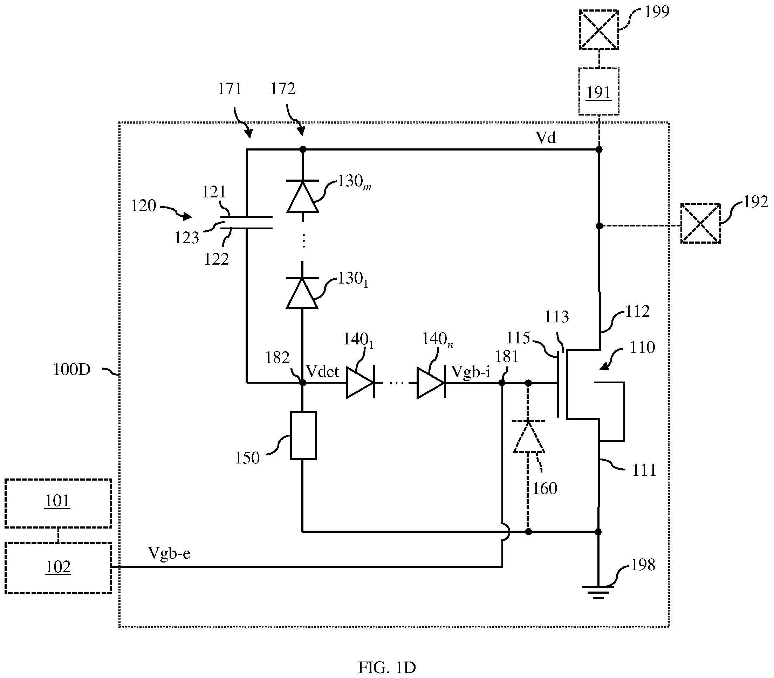

FIG. 1D is a schematic diagram illustrating yet another embodiment of a circuit with a self-protected transistor.

### DETAILED DESCRIPTION

As mentioned above, currently available solutions for avoiding damage to a transistor (e.g., an output driver transistor) caused by an ESD event or other Vd overstress condition can increase chip area and cause switching delay during normal operation.

In view of the foregoing, disclosed herein are embodiments of a circuit that includes a transistor and, particularly, an NFET that is self-protected (i.e., that includes integrated circuitry for protection against damage due to an ESD event or some other drain voltage (Vd) overstress condition). The transistor can include a drain region, a source region connected to ground, and a gate connected to a first node (also referred to herein as a gate bias node). The first node can be connected to receive an externally-generated gate bias voltage (Vgb-e) (e.g., from a control circuit). In some embodiments, the transistor can be an output driver where the drain region is connected to an output pad and where the control circuit that provides Vgb-e is a logic-controlled driver circuit.

In any case, the circuit can further include a resistor-capacitor (RC)-triggered voltage clamp connected in parallel with the transistor. Specifically, the circuit can include a resistor, which is connected between the source region and a second node (also referred to herein as a surging Vd detection node), and a capacitor, which is connected between the second node and the drain region. A first diode or series-connected first diodes can be connected between the second node and the first node. The RC-triggered voltage clamp can detect a surging Vd with a fast rising time (e.g., due to an ESD event) and, in response, can pull-up the voltage (Vdet) on the second node. Depending upon the difference between Vdet at the second node and Vgb-e at the first node, the first diode(s) may become conductive in order to boost the gate voltage with an internally-generated gate bias voltage (Vgb-i) and thereby turn on the transistor to discharge Vd. Optionally, a resistor-diode (RD)-triggered voltage clamp can also be connected in parallel with the transistor. This RD-triggered voltage clamp can share the resistor and second node with the RC-triggered voltage clamp and can further include a second diode or series-connected second diodes connected between the second node and the drain region (i.e., in parallel with the capacitor). The RD-triggered voltage clamp can detect a surging Vd with a slow rising time (e.g., due to some other Vd overstress condition) and, in response, can also pull-up Vdet on the second node. Again, depending upon the difference between Vdet at the second node and Vgb-e at the first node, the first diode(s) may become conductive in order to boost the gate voltage with a Vgb-i and thereby turn on the transistor to discharge Vd. Thus, within the disclosed circuit, the transistor is protected against damage caused by both ESD events and other Vd overstress conditions. Additionally, the inclusion of the first diode(s) within the disclosed circuit may reduce delay that would otherwise be caused by the RC-triggered voltage clamp during normal operation. Finally, the integrated circuitry provided to protect the transistor against ESD and other Vd overstress conditions may also reduce parasitic gate capacitance such that the transistor exhibits increased drain current during normal operation and such that the loading effect is minimized during an ESD event.

More particularly, FIGs. 1A-1D are alternative embodiments of a circuit 100A-100D including a transistor 110. Transistor 110 can specifically be an N-type field effect transistor (NFET). Transistor 110 can include at least the following components: a source region 111, a drain region 112, a channel region 113 between source region 111 and drain region 112, and a gate 115 adjacent to channel region 113. Those skilled in the art will recognize that, within an NFET, source/drain regions 111-112 will typically have N-type conductivity at a relatively high conductivity level (i.e., will be N+ source/drain regions) and channel region 113 will be either undoped or doped so as to have P-type conductivity at a relatively low conductivity level (i.e., will be either an intrinsic or P- channel region). Transistor 110 is an enhancement mode (E-mode) transistor that is normally in an off-state and only turns on (i.e., become conductive) when gate 115 receives a positive gate bias voltage that is at or above the threshold voltage (Vt) of transistor 110.

In circuit 100A-100D, source region 111 can be electrically connected to a ground rail 198 and gate 115 can be electrically connected to a first node 181 (also referred to herein as a gate bias node). First node 181 can be electrically connected to a control circuit 102 for receiving an externally-generated gate bias voltage (Vgb-e) as the primary control for the on/off state of transistor 110 during normal operation. Drain region 112 can be electrically connected to another component and can be sensitive to ESD and/or some other drain voltage overstress condition particularly when Vgb-e is at 0.0V or otherwise relatively low (i.e., below Vt).

In some embodiments, transistor 110 can be employed as an output driver. In this case, control circuit 102 can be a driver circuit. Optionally, the driver circuit can be controlled by a logic circuit 101 (i.e., can be a logic-controlled diver circuit). Various different logic-controlled driver circuits are well known in the art and, thus, the details thereof have been omitted from this specification in order to allow the reader to focus on the salient aspects of the disclosed embodiments (e.g., related to self-protection of transistor 110). In an output driver, drain region 112 of transistor 110 can be electrically connected to one or more output pads 199, 192 either directly (e.g., see output pad 192) or, optionally, via a switch 191 (e.g., a P-type field effect transistor (PFET)) (e.g., see output pad 199). Output pad(s) 199, 192 can be electrically connected, for example, to external pin(s) that can be contacted by humans or machines and as a result can receive a static shock (i.e., a flow of static electricity). It should be noted that, if employed as an output driver, transistor 110 could be a high voltage (HV) NFET. The HV NFET could be a symmetric NFET with a relatively large channel width to enable HV operation. Alternatively, the HV NFET could be an asymmetric NFET, such as an N-type laterally-diffused metal oxide semiconductor field effect transistor (NLDMOSFET), to enable HV operation. In other embodiments, transistor 110 could be employed as a HV NFET, logic NFET, or any other type of NFET, which has a gate 115 that receives an externally-generated gate bias voltage (Vgb-e) from a control circuit 102 and which has a drain region 112 that is ESD-sensitive and/or otherwise sensitive to Vd overstress conditions. Thus, circuit 100A-100D could be formed using any high voltage, bipolar-complementary metal oxide semiconductor-double diffused metal oxide semiconductor (BCD), or logic processing technology. In any case, various different NFET structures, including HV NFETs, NLDMOSFETs, logic NFETs, etc., are well known in the art. Thus, the details thereof have been omitted from this specification in order to allow the reader to focus on the salient aspects of the disclosed embodiments related to self-protection, as discussed in greater detail below.

Referring again to FIGs. 1A-1D, transistor 110 can be a self-protected transistor. That is, it can include integrated circuitry that provides protection against damage due to an ESD event or some other Vd overstress condition. Specifically, to achieve this self-protection, circuit 100A-100D can include a resistor-capacitor (RC)-triggered voltage clamp 171 and a first diode 140 or a chain of series-connected first diodes 140₁-140*ₙ*. Optionally, circuit 100A-100D can also include a resistor-diode (RD)-triggered voltage clamp 172 and/or a third diode 160.

Specifically, RC-triggered clamp 171 can be connected in parallel with transistor 110. RC-triggered voltage clamp 171 can include a resistor 150, which is electrically connected between source region 111 of transistor 110 and a second node 182 (also referred to herein as a surging Vd detection node), and a capacitor 120, which is electrically connected between second node 182 and drain region 112 of transistor 110. Capacitor 120 can be any suitable high voltage capacitor. For example, capacitor 120 can be a metal-insulator-metal (MIM) capacitor, a metal-oxide-metal (MOM) capacitor, etc. In some embodiments, capacitor 120 can be a polarized capacitor (e.g., a Miller compensation capacitor). Such capacitors are well known in the art and, thus, the details thereof have been omitted from this specification in order to allow the reader to focus on the salient aspects of the disclosed embodiments. In any case, capacitor 120 can include one capacitor plate 121 (e.g., a positive capacitor plate) electrically connected to drain region 112, another capacitor plate 122 (e.g., a negative capacitor plate) electrically connected to second node 182, and a capacitor dielectric 123 between and immediately adjacent to the capacitor plates 121-122. The RC time constant of RC-triggered voltage clamp 171 can be relatively low (e.g., within the range of approximately 100 nanoseconds (ns) to approximately 1.0 microseconds (µs)). Thus, during normal operation, capacitor 120 blocks direct current (DC) flow and Vdet at second node 182 will be at 0.0V. However, in response to an ESD event or some other event causing Vd to surge at a fast rate, the voltage (Vdet) on second node 182 can be pulled up. That is, RC-triggered voltage clamp 171 can be configured to detect a surging Vd (e.g., Vd rising to 30.0V or higher with a relatively fast rising time, such as a rising time in the range of approximately 0.1 ns to approximately 10.0 ns ) and, in response, pull-up Vdet to some predetermined level.

Additionally, a first diode 140 can be electrically connected between second node 182 and first node 181 (and thereby electrically connected between second node 182 and gate 115 of transistor 110) (see circuits 100A and 100B of FIGs. 1A and 1B, respectively). Alternatively, a chain of two or more series-connected first diodes 140₁-140*ₙ* can be electrically connected between second node 182 and first node 181 (and thereby electrically connected between second node 182 and gate 115 of transistor 110) (see circuits 100C and100D of FIGs. 1C and 1D, respectively). The anode terminal of first diode 140 (or of the initial first diode 140₁ in the chain) can be electrically connected to second node 182 and the cathode terminal of first diode 140 (or of the last first diode 140*ₙ* in the chain) can be electrically connected to first node 181. Each first diode 140 or 140₁-140*ₙ* can be a standard diode. Standard diodes are well known in the art and, thus, the details thereof have been omitted from this specification in order to allow the reader to focus on the salient aspects of the disclosed embodiments. However, those skilled in the art will recognize that in such a standard diode current will flow only in the standard direction (i.e., from anode terminal to cathode terminal) and only when forward biasing with a positive voltage on the anode terminal reaches a particular forward voltage level (as a function of the potential difference between the terminals). Additionally, a forward voltage drop equal to this forward voltage level will be exhibited between the input and output of the diode. For series-connected diodes, the total forward voltage drop will be equal to the sum of the forward voltage drops associated with each diode.

With the disclosed configuration, instead of applying Vdet directly to first node 181 and thereby to gate 115 of transistor 110 in order to switch transistor 110 into an on-state (e.g., when Vgb-e provided by control circuit 102 is at 0.0V or close thereto). Vdet is applied to the input of first diode 140 (or to the input of the chain of series-connected first diodes 140₁-140*ₙ*) to provide forward biasing. Depending upon the difference between Vdet at second node 182 and Vgb-e applied to first node 181 by control circuit 102, first diode 140 or, if applicable, series-connected first diodes 140₁-140*ₙ* may become conductive in order to quickly boost the voltage applied to gate 115 with an internally-generated gate bias voltage (Vgb-i) and thereby turn on transistor 110 to discharge ESD stress on drain region 112. That is, when the voltage differential between Vdet and Vgb-e rises above the forward voltage level, first diode(s) 140 or 140₁-140*ₙ* will turn on and Vgb-i will be applied along with Vgb-e to gate 115 through first node 181.

It should be noted that the size and/or numbers of first diode(s) can be predetermined to achieve optimal for performance. For example, given an expected ESD current (e.g., 1.3 amperes (A) of ESD stress discharge at human body model (HBM) of 2 kilovolts (kV)), the known forward voltage drop for the first diode(s), and the expected level of Vdet, the combination of Vgb-e and Vgb-i will equal to the optimal gate bias voltage to be applied to transistor 110 to ensure that Vd is less than the drain-source breakdown voltage (BVDSS) of transistor 110. Thus, if BVDSS of transistor 110 is 30.0V, then the optimal gate bias voltage for ensuring that Vd stays below 30.0V (e.g., at 26V) could be approximately 3.0V. In this case, if RC-triggered voltage clamp 171 is configured so that, when it turns on in response to an ESD event, Vdet on second node 182 will be at 3.8V, then the first diode(s) can be selected so that, given the forward voltage drop, Vgb-i on first node 181 will be .8V lower (i.e., at 3.0V).

Optionally, additional self-protection can be provided by an RD-triggered voltage clamp 172. RD-triggered voltage clamp 172 can share resistor 150 and second node 182 with RC-triggered voltage clamp 171. Additionally, RD-triggered voltage clamp 172 can include a second diode 130 electrically connected between second node 182 and drain region 112 of transistor 110 (see circuits 100A and 100C of FIGs. 1A and 1C, respectively). Alternatively, RD-triggered voltage clamp 172 can include a chain of two or more series-connected second diodes 130₁-130*ₘ* electrically connected between second node 182 and drain region 112 of transistor 110 (see circuits 100B and 100D of FIGs. 1B and 1D, respectively). The anode terminal of second diode 130 (or of the initial second diode 130₁ in the chain) can be electrically connected to second node 182 and the cathode terminal of second diode 130 (or of the last second diode 130*ₘ* in the chain) can be electrically connected to drain region 112 of transistor 110.

Each second diode 130 or 130₁-130*ₘ* in RD-triggered voltage clamp 172 can be a Zener diode. Zener diodes are well known in the art and, thus, the details thereof have been omitted from this specification in order to allow the reader to focus on the salient aspects of the disclosed embodiments. However, those skilled in the art will recognize that a Zener diode is a diode that allows current to flow in either direction depending upon the biasing conditions. When forward biasing (i.e., application of a positive voltage to the anode terminal and a negative or ground voltage to the cathode terminal) reaches the particular forward voltage level, the Zener diode functions as a normal diode and current will flow in the standard direction from the anode terminal toward the cathode terminal. However, when reverse biasing (i.e., application of a positive voltage to the cathode terminal and a negative or ground voltage to the anode terminal) reaches a particular reverse voltage level, a small amount of current will flow in the reverse direction from the cathode terminal toward the anode terminal. During normal operation, the second diode(s) blocks direct current (DC) flow and Vdet at second node 182 will be at 0.0V. However, in response to an event causing Vd to surge at a relatively slow rate (i.e., at a rate slower than ESD stress's rising time) and to a level at or above a maximum operating voltage rating of transistor 110, the voltage (Vdet) on second node 182 can be pulled up. For example, for a transistor with a maximum operating voltage rating of 30.0V, RD-triggered voltage clamp 172 can be configured to detect a surging Vd (e.g., Vd rising to 30.0V or higher with a slow rising time) and, in response, pull-up Vdet to some predetermined level. The total number (*m*) of second diodes can be preselected for optimal performance and can be up to four or more second diodes.

Optionally, additional self-protection can be provided by a third diode 160. Third diode 160 can be electrically connected between source region 111 of transistor 110 and first node 181 (see circuits 100A-100D of FIGs. 1A-1D, respectively). Third diode 160 can also be a Zener diode. In this case, such a Zener diode can be employed to prevent a violation of a maximum gate-source voltage rating (maxVGS) for the transistor. That is, if the voltage level at first node 181 reaches a particular reverse voltage level, a small amount of current will flow in the reverse direction from the cathode terminal toward the anode terminal, pulling down the voltage level on first node 181 and thereby pulling down the voltage being applied to gate 115.

Therefore, within circuits 100A-100D of FIGs. 1A-1D, respectively, transistor 110 is protected by RC-triggered voltage clamp 171 and by RD-triggered voltage clamp 172 against damage caused by both ESD events and other Vd overstress conditions. Additionally, the inclusion of first diode(s) 140 or 140₁-140*ₙ* within these circuits 100A-100D may reduce delay that would otherwise be caused by RC-triggered voltage clamp 171 during normal operation. Finally, the integrated circuitry provided to protect the transistor against ESD and other Vd overstress conditions as discussed above may also reduce parasitic gate capacitance such that transistor 110 exhibits increased drain current (Id) during normal operation and such that the loading effect is minimized during an ESD event.

It should be understood that in the method and structures described above, a semiconductor material refers to a material whose conducting properties can be altered by doping with an impurity. Exemplary semiconductor materials include, for example, silicon-based semiconductor materials (e.g., silicon, silicon germanium, silicon germanium carbide, silicon carbide, etc.) and III-V compound semiconductors (i.e., compounds obtained by combining group **III** elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group **III** dopant, such as boron (B) or indium (In), to achieve P-type conductivity, whereas a silicon-based semiconductor material is typically doped with a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, a circuit including a transistor with integrated circuitry for protection against damage due to an electrostatic discharge (ESD) event or other drain voltage (Vd) overstress condition is disclosed in various embodiments. The transistor is an N-type field effect transistor (NFET) and includes a drain region, a source region connected to ground, and a gate connected to a first node. The first node is connected to receive an externally-generated gate bias voltage. A resistor-capacitor (RC)-triggered voltage clamp is connected in parallel with the transistor. Specifically, a resistor is connected between the source region and a second node and a capacitor is connected between the second node and the drain region. A first diode or series-connected first diodes is/are connected between the second node and the first node. Optionally, a resistor-diode (RD)-triggered voltage clamp is also connected in parallel with the transistor and shares the resistor and second node with the RC-triggered voltage clamp.

The following embodiments are explicitly disclosed.

### Embodiment 1:

A circuit comprising:
a transistor including a source region, a drain region and a gate, wherein the gate is connected to a first node;
a resistor connected between the source region and a second node;
a capacitor connected between the second node and the drain region; and
a first diode connected between the second node and the first node.

For example, the first diode may be one first diode. Alternatively, the first diode may be one diode of a plurality of diodes representing series-connected first diodes between the second node and the first node. Accordingly, the circuit may comprise at least one first diode connected between the second node and the first node.

### Embodiment 2:

The circuit of embodiment 1, further comprising a second diode connected in parallel with the capacitor between the second node and the drain region.

For example, the second diode may be one second diode. Alternatively, the second diode may be one diode of a plurality of diodes representing series-connected second diodes in parallel with the capacitor between the second node and the drain region. Accordingly, the circuit may comprise at least one second diode connected between the second node and drain region.

In some illustrative examples of Embodiment 2, the transistor may haves a maximum operating voltage. When a drain voltage of the drain region of the transistor surges up to at least the maximum operating voltage and at a surge rate slower than a surge rate of electrostatic discharge, then the at least one second diode may turn on to pull up a voltage on the second node above 0.0 volts.

### Embodiment 3:

The circuit of embodiment 1 or 2, wherein the first node is connected to receive a gate bias voltage from a control circuit.

In some illustrative examples of Embodiment 3, the gate bias voltage from the control circuit may be an externally-generated gate bias voltage. When a voltage differential between a voltage on the second node and the externally-generated gate bias voltage rises above a predetermined forward voltage level, then the at least one first diode may turn on and an internally-generated gate bias voltage may be applied with the externally-generated gate bias to the gate of the transistor through the first node.

**In** some other illustrative examples of Embodiment 3,the control circuit may include a logic-controlled driver circuit

### Embodiment 4:

The circuit of one of embodiments 1 to 3, further comprising a third diode connected between the source region and the first node.

### Embodiment 5:

The circuit of embodiment 4, wherein the third diode comprises a Zener diode.

In some illustrative examples of Embodiment 5, the transistor may have a maximum gate-source voltage and the third diode may protect the transistor against a violation of the maximum gate-source voltage

### Embodiment 6:

The circuit of one of embodiments 1 to 5, wherein the source region is connected to ground and the drain region is connected to an output pad.
In some illustrative examples of Embodiment 6, the circuit may further comprise a switch connected between the drain region and the output pad.

### Embodiment 7:

The circuit of one of embodiments 1 to 6, wherein the transistor comprises an N-type field effect transistor.

### Embodiment 8:

The circuit of one of embodiments 1 to 7, wherein the transistor comprises an N-type laterally diffused metal oxide semiconductor field effect transistor.

### Embodiment 9:

A circuit comprising:
a transistor including a source region, a drain region and a gate, wherein the gate is connected to a first node;
a resistor connected between the source region and a second node;
a capacitor connected between the second node and the drain region;
series-connected first diodes between the second node and the first node; and
any of a second diode and series-connected second diodes connected in parallel with the capacitor between the second node and the drain region.

### Embodiment 10:

The circuit of embodiment 9, wherein the first node is connected to receive a gate bias voltage from a control circuit.

### Embodiment 11:

The circuit of embodiment 9 or 10, further comprising a third diode connected between the source region and the first node.

### Embodiment 12:

The circuit of embodiment 11, wherein the third diode comprises a Zener diode.

### Embodiment 13:

The circuit of one of embodiments 9 to 12, wherein the source region is connected to ground and the drain region is connected to an output pad.

### Embodiment 14:

The circuit of one of embodiments 9 to 13, wherein the transistor comprises an N-type field effect transistor.

### Embodiment 15:

A circuit comprising:
a transistor including a source region, a drain region and a gate, wherein the gate is connected to a first node;
a resistor connected between the source region and a second node;
a capacitor connected between the second node and the drain region;
any of a first diode and series-connected first diodes connected between the second node and the first node; and
series-connected second diodes connected in parallel with the capacitor between the second node and the drain region.

### Embodiment 16:

The circuit of embodiment 15, wherein the first node is connected to receive a gate bias voltage from a control circuit.

### Embodiment 17:

The circuit of embodiment 15 or 16, further comprising a third diode connected between the source region and the first node.

### Embodiment 18:

The circuit of embodiment 17, wherein the third diode comprises a Zener diode.

### Embodiment 19:

The circuit of one of embodiments 15 to 18, wherein the source region is connected to ground and the drain region is connected to an output pad.

### Embodiment 20:

The circuit of one of embodiments 15 to 19, wherein the transistor comprises an N-type field effect transistor.

Any of the Embodiments 9 and 15 may be combined with any of the embodiments 2 to 8.

## Claims

1. A circuit comprising:
a transistor including a source region, a drain region and a gate, wherein the gate is connected to a first node;
a resistor connected between the source region and a second node;
a capacitor connected between the second node and the drain region; and
at least one first diode connected between the second node and the first node.

2. The circuit of claim 1, further comprising at least one second diode connected in parallel with the capacitor between the second node and the drain region.

3. The circuit of claim 2, wherein the transistor has a maximum operating voltage, and wherein, when a drain voltage of the drain region of the transistor surges up to at least the maximum operating voltage and at a surge rate slower than a surge rate of electrostatic discharge, then the at least one second diode turns on to pull up a voltage on the second node above 0.0 volts.

4. The circuit of one of claims 1 to 3, wherein the first node is connected to receive a gate bias voltage from a control circuit.

5. The circuit of claim 4,
wherein the gate bias voltage from the control circuit is an externally-generated gate bias voltage, and
wherein, when a voltage differential between a voltage on the second node and the externally-generated gate bias voltage rises above a predetermined forward voltage level, then the at least one first diode turns on and an internally-generated gate bias voltage is applied with the externally-generated gate bias to the gate of the transistor through the first node.

6. The circuit of claim 4 or 5, wherein the control circuit includes a logic-controlled driver circuit.

7. The circuit of one of claims 1 to 6, further comprising a third diode connected between the source region and the first node.

8. The circuit of claim 7, wherein the third diode comprises a Zener diode.

9. The circuit of claim 8, wherein the transistor has a maximum gate-source voltage and the third diode protects the transistor against a violation of the maximum gate-source voltage.

10. The circuit of one of claims 1 to 9, wherein the source region is connected to ground and the drain region is connected to an output pad.

11. The circuit of claim 10, further comprising a switch connected between the drain region and the output pad.

12. The circuit of one of claims 1 to 11, wherein the transistor comprises an N-type field effect transistor.

13. The circuit of one of claims 1 to 12, wherein the transistor comprises an N-type laterally diffused metal oxide semiconductor field effect transistor.

14. The circuit of one of claims 1 to 13, further comprising any of a second diode and series-connected second diodes connected in parallel with the capacitor between the second node and the drain region, wherein a plurality of series connected first diodes is connected between the second node and the first node.

15. The circuit of any of claims 1 to 14, further comprising series-connected second diodes connected in parallel with the capacitor between the second node and the drain region.
